# EUROPEAN PATENT SPECIFICATION

(11) **EP 3 770 947 B1**
(45) Date of publication and mention of the grant of the patent: **07.06.2023**
(21) Application number: 18910945.7
(22) Date of filing: 28.11.2018
(51) Int. Cl.: H01L 21/02, H01J 37/34, C23C 14/50

(54) **POWER FEEDING MECHANISM, ROTATING BASE APPARATUS, AND SEMICONDUCTOR PROCESSING DEVICE**
STROMVERSORGUNGSMECHANISMUS, ROTIERENDE BASISVORRICHTUNG UND HALBLEITERVERARBEITUNGSVORRICHTUNG
MÉCANISME D'ALIMENTATION ÉLECTRIQUE, APPAREIL À BASE ROTATIVE, ET DISPOSITIF DE TRAITEMENT DE SEMI-CONDUCTEUR

(30) Priority: 19.03.2018 CN 201820370506 U; 19.03.2018 CN 201810224905
(43) Date of publication of application: 27.01.2021
(73) Proprietor: Beijing NAURA Microelectronics Equipment Co., Ltd., Beijing 100176 (CN)
(72) Inventor: LIU, Jiansheng, Beijing 100176 (CN); LI, Liang, Beijing 100176 (CN); JIANG, Xinxian, Beijing 100176 (CN); CHEN, Peng, Beijing 100176 (CN); WEN, Lihui, Beijing 100176 (CN)
(74) Representative: Cohausz & Florack
(86) International application number: PCT/CN2018/117901
(87) International publication number: WO 2019/179159

(56) References cited:
- WO-A1-2016/156860
- CN-A- 102 469 675
- CN-A- 106 163 069
- CN-A- 106 163 069
- CN-A- 107 240 565
- CN-A- 108 461 387
- CN-U- 208 014 650
- JP-A- 2003 092 343
- JP-A- 2004 273 406
- US-A1- 2014 261 161
- US-A1- 2015 197 847
- US-A1- 2017 169 995
- US-A1- 2018 047 547

## Description

### TECHNICAL FIELD

The present disclosure relates to the field of semiconductor manufacturing technology, and in particular, to a power feeding mechanism, a rotary base device, and semiconductor processing equipment.

### BACKGROUND

In a physical vapor deposition (PVD) process, the power output from a sputtering power supply is coupled to a processing chamber through an electrode to excite a process gas in the chamber to form plasma, and thin film deposition is achieved under the action of electrons and ions in the plasma.

With the increase of wafer size, there are higher and higher requirements for the uniformity of a deposited thin film in the PVD process in order to improve the yield of products. The uniformity of the deposited thin film can be significantly improved by using a rotating base, which has been widely used. A radio frequency is generally fed into a base to increase the energy of charged ions in the plasma and enhance the bombardment effect of the ions, but it is a challenge to maintain good and stable radio frequency connection during the rotation of the base.

In the prior art, generally, two mutually embedded inductance coils are disposed around a rotatable base supporting member; by using a magnetic field generated by the inductance coils, radio frequency energy can be coupled to the base supporting member by means of magnetic field coupling, so as to transmit radio frequency power to the base that is rotating. However, following problems are inevitable in practical applications.

Firstly, the power transmission efficiency is low due to magnetic flux leakage occurring when the radio frequency power is transmitted by means of inductive coupling through the inductance coils.

Secondly, in order to increase the radio frequency power that is fed into the base supporting member, a voltage of the inductance coils needs to be increased, but there is a risk of ignition when the voltage is increased to a certain threshold. In US2014/261161 A1, a substrate holder apparatus includes a substrate holder configured to hold a substrate in a vacuum processing space in a chamber, a support column coupled to the substrate holder, a first rotating support unit which rotatably supports the support column, a second rotating support unit which rotatably supports the support column at a position spaced apart from a position where the first rotating support unit supports the support column, a housing configured to support the first rotating support unit and the rotating support unit, and a conductive member configured to electrically connect the support column to the housing. US2018/047547 A1 provides a slip ring including: a conductive rotor that is rotatable around a rotation axis; a conductive stator provided coaxially with the rotor; a conductive sphere disposed between the rotor and the stator to form an electric path between the rotor and the stator; and a conductive coil spring provided between the sphere and one of the rotor and the stator and extending in a circumferential direction with respect to the rotation axis to be in contact with the sphere and one of the rotor and the stator. In US2017/169995 A1, an isolation system includes an input junction coupled to one or more RF power supplies via a match network for receiving radio frequency power. The isolation system further includes a plurality of channel paths connected to the input junction for distributing the RF power among the channel paths. The isolation system includes an output junction connected between each of the channel paths and to an electrode of a plasma chamber for receiving portions of the distributed RF power to output combined power and providing the combined RF power to the electrode. Each of the channel paths includes bottom and top capacitors for blocking a signal of the different type than that of the RF power. WO2016/156860 A1 provides an electrical contact, in which electrical power needs to be transmitted from an essentially static part of the apparatus on the atmosphere side, to a dynamic (rotating) part on the vacuum side. The electrical contact provides an electrical connection across a dynamic (moving) interface between a first static part and a second dynamic part and comprises a liquid retained, and interposed, between the static and dynamic parts. The liquid comprises a high electrical conductivity liquid. US2015/197847 A1 provides an endblock for a rotatable sputtering target. A sputtering apparatus, including one or more such endblock(s), includes locating the electrical contact(s) between the collector and rotor in the endblock(s) in an area under vacuum (as opposed to in an area at atmospheric pressure). In JP2004 273406 A, a conductive planet ring is characterized in that it is endowed with elasticity and having a diameter larger than the gap between an inner ring and an outer ring of a concentric conductor is inserted into the gap. The mechanism of the planet ring elliptically compressed by rotation of the outer ring or the inner ring (or a relative rotation in case the both rings are rotated) of making a rolling sun-and-planet motion around an axis while insulation displacingbetween the both rings at all times by repulsive force coming from the planet ring elliptically compressed makes use of parts insulation displaced between the both conductive rings and the planet ring as electric contacts.

### SUMMARY

In order to solve at least one of the problems in the prior art, the present disclosure provides a power feeding mechanism, according to claim 1, a rotary base device, according toclaim 8, and a semiconductor processing equipment, according to claim 9, which can not only improve the power transmission efficiency, but also avoid the risk of ignition in the prior art.

Preferred embodiments of the present disclosure are defined in the dependent claims.

The present disclosure has the following beneficial effects:
in the power feeding mechanism, the rotary base device and the semiconductor processing equipment of the present disclosure, the conductive connecting structure is in electrical contact respectively with the conductive stationary member and the conductive rotating member without affecting the rotation of the conductive rotating member, so that the power can be transmitted to the rotating component that is rotating. Meanwhile, because the conductive connecting structure is in electrical contact respectively with the conductive stationary member and the conductive rotating member, the power transmission efficiency is higher and the risk of ignition in the prior art can be avoided as compared with transmitting the power by means of inductive coupling in the prior art.

### BRIEF DESCRIPTION OF THE DRAWINGS

Fig. 1 is a structural diagram of a power feeding mechanism according to a first embodiment of the present disclosure;
Fig. 2 is another structural diagram of the power feeding mechanism according to the first embodiment of the present disclosure;
Fig. 3 is still another structural diagram of the power feeding mechanism according to the first embodiment of the present disclosure;
Fig. 4 is a structural diagram of a power feeding mechanism according to a second embodiment of the present disclosure;
Fig. 5 is a structural diagram of a power feeding mechanism according to a third embodiment of the present disclosure;
Fig. 6 is a structural diagram of a power feeding mechanism according to a fourth embodiment of the present disclosure; and
Fig. 7 is a structural diagram of semiconductor processing equipment according to a fifth embodiment of the present disclosure.

### DETAILED DESCRIPTION

In order to enable those skilled in the art to better understand the technical solutions of the present disclosure, the power feeding mechanism, the rotary base device and the semiconductor processing equipment provided by the present disclosure are described in detail below with reference to the accompanying drawings.

The power feeding mechanism provided by the present disclosure is used for feeding output power of a power source into a rotating component. The rotating component may be a base, a target, a coil, etc. The power source usually includes a matcher and a power supply. The matcher is used to dynamically adjust a variable capacitor in a matching circuit in a processing process to make load impedance be matched with output impedance of the power supply, so as to ensure that the output power of the power supply is applied to the plasma inside a chamber to the greatest extent. The power supply includes a radio frequency power supply, a low frequency power supply, an intermediate frequency power supply, a direct current power supply, or the like.

Specifically, the power feeding mechanism includes: a conductive stationary member, a conductive rotating member and a conductive connecting structure. The conductive stationary member is electrically connected with the power source; the conductive rotating member is electrically connected and synchronously rotates with the rotating component; and the conductive connecting structure is in electrical contact with the conductive stationary member and the conductive rotating member, respectively, without affecting the rotation of the conductive rotating member. In this way, the output power of the power source can be fed into the rotating component that is rotating. Meanwhile, because the conductive connecting structure is in electrical contact with the conductive stationary member and the conductive rotating member, respectively, the power transmission efficiency is higher and the risk of ignition in the prior art can be avoided as compared with transmitting the power by means of inductive coupling in the prior art.

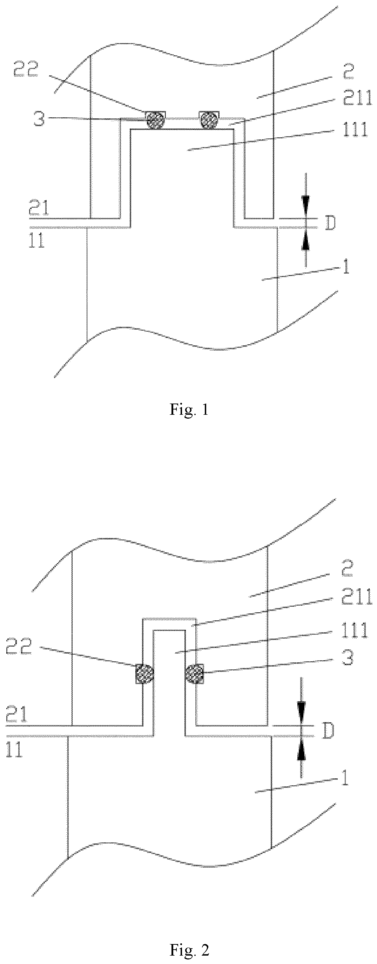

The specific implementations of the conductive connecting structure are described in detail below. Specifically, with reference to Fig. 1, in the power feeding mechanism according to a first embodiment of the present disclosure, a conductive rotating member 2 is disposed opposite to and spaced apart from a conductive stationary member 1. A conductive connecting structure is provided in a gap between the conductive rotating member 2 and the conductive stationary member 1 to electrically connect the conductive rotating member 2 to the conductive stationary member 1, thereby achieving power transmission.

In the embodiment, the conductive rotating member 2 includes a first surface 21, the conductive stationary member 1 includes a second surface 11, and the first surface 21 is opposite to and spaced apart from the second surface 11. Preferably, a vertical length of the gap between the conductive rotating member 2 and the conductive stationary member 1 is greater than or equal to 1mm, that is, there is a distance D between the first surface 21 and the second surface 11, and D is greater than or equal to 1mm. In this way, it can be ensured that the rotation of the conductive rotating member 2 is not affected. The conductive stationary member 1 and the conductive rotating member 2 are preferably made of a material having good conductivity, such as copper.

In the embodiment, the two opposite surfaces (the first surface 21 and the second surface 11) of the conductive rotating member 2 and the conductive stationary member 1 are parallel to each other or are embedded in each other, so as to improve structural stability. In the embodiment, a concave portion 211 is provided on the first surface 21, and a convex portion 111 is correspondingly provided on the second surface 11; and the convex portion 111 is located in the concave portion 211, so that the conductive rotating member 2 and the conductive stationary member 1 are embedded in each other. In practical applications, the convex portion may be provided on the first surface 21, and the concave portion may be correspondingly provided on the second surface 11.

In the embodiment, the conductive connecting structure includes a first elastic conductive member 3. Due to its elasticity, the first elastic conductive member 3 can always be kept in electrical contact with the conductive rotating member 2 during the rotation of the conductive rotating member 2, so as to ensure normal power transmission. Meanwhile, the first elastic conductive member 3 does not affect the rotation of the conductive rotating member. The first elastic conductive member 3 may be made of a soft material, for example, a soft alloy such as an aluminum alloy and a stainless steel alloy.

It should be noted that the first elastic conductive member 3 is located between a bottom surface of the concave portion 211 and a top surface of the convex portion 111 in the embodiment, but the present disclosure is not limited thereto. In practical applications, as shown in Fig. 2, the first elastic conductive member 3 may be located between an inner wall surface of the concave portion 211 and an outer wall surface of the convex portion 111.

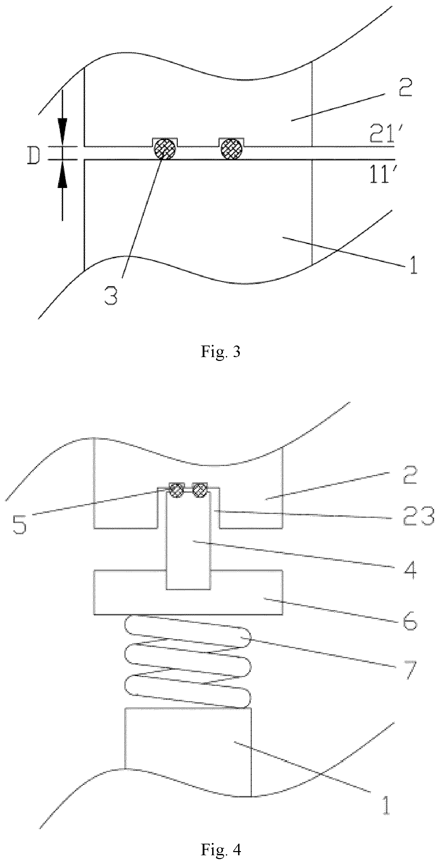

It should be noted that the conductive rotating member 2 and the conductive stationary member 1 are embedded in each other through the concave portion 211 and the convex portion 111 in the embodiment, but the present disclosure is not limited thereto. In practical applications, as shown in Fig. 3, both a first surface 21' and a second surface 11' are flat surfaces, and the first elastic conductive member 3 is disposed between the first surface 21' and the second surface 11'.

In the embodiment, the first elastic conductive member 3 is a ring body. In practical applications, the first elastic conductive member 3 may be any other structure such as a planar spiral body (like a spiral body of an incense coil) or a columnar spiral body.

In the embodiment, a mounting groove 22 is provided on the first surface 21, and part of the first elastic conductive member 3 is disposed in the mounting groove 22 to mount the first elastic conductive member 3. It is easily understood that the other part of the first elastic conductive member 3 is located outside the mounting groove 22 to guarantee the electrical contact with the second surface 11 of the conductive stationary member 1. In practical applications, the mounting groove may be provided on the second surface 11, or it is also possible to arrange corresponding mounting grooves respectively on the first surface 21 and the second surface 11.

It should be noted that the number of the first elastic conductive member 3 in the embodiment is one, but the present disclosure is not limited thereto. In practical applications, a plurality of annular first elastic conductive members 3 may be provided and embedded in each other. For the first elastic conductive members 3 having other structures, any other arrangement may be applicable.

Compared with the power feeding mechanism provided in the first embodiment, the power feeding mechanism provided in a second embodiment of the present disclosure also includes a conductive stationary member, a conductive rotating member and a conductive connecting structure, but the conductive connecting structure has a different structure. Only the differences between the second embodiment and the first embodiment are described below.

Specifically, with reference to Fig. 4, the conductive connecting structure includes: a spring 7, a second elastic conductive member 4, and a third elastic conductive member 5. A first end of the spring 7 (a lower end of the spring 7 in Fig. 4) is connected to the conductive stationary member 1, and a second end of the spring 7 (an upper end of the spring 7 in Fig. 4) is connected to the second elastic conductive member 4. The third elastic conductive member 5 is disposed on the second elastic conductive member 4, and is kept in electrical contact with the conductive rotating member 2 under the action of the elastic force of the spring 7.

The hardness of the second elastic conductive member 4 is lower than that of the third elastic conductive member 5. In practical applications, the conductive rotating member 2 drives the third elastic conductive member 5 to rotate together, which causes relative movement between the third elastic conductive member 5 and the second elastic conductive member 4. Since the hardness of the second elastic conductive member 4 is lower than that of the third elastic conductive member 5, the second elastic conductive member 4, which is softer, is more likely to be worn by the third elastic conductive member 5, so that the wear of the third elastic conductive member 5 is reduced and the service life of the third elastic conductive member 5 is prolonged.

Meanwhile, even if the second elastic conductive member 4 is worn thin, the electrical contact between the third elastic conductive member 5 and the conductive rotating member 2 can still be kept in good condition under the action of the elastic force of the spring 7, thereby ensuring stable power transmission.

In practical applications, under the condition that the hardness of the second elastic conductive member 4 is lower than that of the third elastic conductive member 5, the second elastic conductive member 4 may be made of a soft material such as graphite or a soft alloy. The third elastic conductive member 5 may be made of a soft material such as a soft alloy. The graphite powder generated by graphite during operation can lubricate the third elastic conductive member 5, so as to further reduce the wear of the third elastic conductive member 5.

Like the first elastic conductive member 3 in the first embodiment, the third elastic conductive member 5 may be a ring body, a planar spiral body, a columnar spiral body, or the like.

Optionally, the spring 7 may be an elastic member such as a cylindrical coil spring.

In the embodiment, the conductive rotating member 2 is provided with a recess 23, and at least a part of the second elastic conductive member 4 is located in the recess 23, so that the conductive rotating member 2 and the second elastic conductive member 4 can be embedded in each other to improve structural stability.

Optionally, the conductive connecting structure further includes a fixing seat 6 connected to the spring 7; and a mounting groove is provided on the fixing seat 6, and the second elastic conductive member 4 is detachably fixed in the mounting groove. In this way, after the second elastic conductive member 4 is worn to a certain extent, the second elastic conductive member 4 can be separated from the conductive rotating member 2 by pressing the fixing seat 6 downward, then taken away from the mounting groove, and replaced with a new second elastic conductive member 4, which is easier than replacing the third elastic conductive member 5, thereby increasing work efficiency.

Compared with the power feeding mechanism provided in the second embodiment, the power feeding mechanism provided in a third embodiment of the present disclosure also includes a conductive stationary member, a conductive rotating member and a conductive connecting structure, but the conductive connecting structure has a different structure. Only the differences between the third embodiment and the second embodiment are described below.

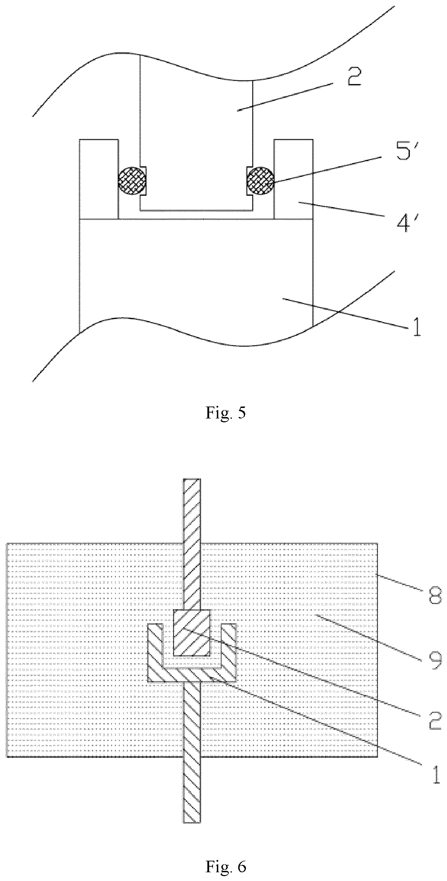

Specifically, with reference to Fig. 5, the conductive connecting structure includes: a second elastic conductive member 4' and a third elastic conductive member 5', and the second elastic conductive member 4' is connected with the conductive stationary member 1 and is a ring body that is disposed around the conductive rotating member 2. The third elastic conductive member 5' is connected with the conductive rotating member 2, located between an inner wall surface of the ring body and an outer wall surface of the conductive rotating member 2, and in electrical contact with the ring body and the conductive rotating member 2 respectively. The hardness of the second elastic conductive member 4' is lower than that of the third elastic conductive member 5'.

The third elastic conductive member 5' synchronously rotates with the conductive rotating member 2, which causes relative movement between the third elastic conductive member 5'and the second elastic conductive member 4'. Since the hardness of the second elastic conductive member 4' is lower than that of the third elastic conductive member 5', the second elastic conductive member 4', which is softer, is more likely to be worn by the third elastic conductive member 5', so that the wear of the third elastic conductive member 5' is reduced and the service life of the third elastic conductive member 5' is prolonged.

The power feeding mechanism provided in a fourth embodiment of the present disclosure is obtained by making an improvement to the power feeding mechanisms provided by the above embodiments.

Specifically, with reference to Fig. 6, a conductive connecting structure includes a conductive liquid container 8 filled with a conductive liquid 9, and a part of the conductive stationary member 1 and a part of the conductive rotating member 2 are immersed in the conductive liquid 9 in the conductive liquid container 8, so as to electrically connect the conductive stationary member 1 to the conductive rotating member 2 through the conductive liquid. Besides having good conductivity, the conductive liquid has stable conductivity because it does not settle or agglomerate even being used for a long time. The conductive liquid may be mercury, a conductive carbon-based solvent, a conductive ionic solution, or any other conductive liquid.

In practical applications, the conductive liquid container 8 may be connected to the conductive stationary member 1, and in this case, the conductive liquid container 8 is fixed relative to the conductive rotating member 2 that is rotating; or, the conductive liquid container 8 may be connected to the conductive rotating member 2, and in this case, the conductive liquid container 8 synchronously rotates with the conductive rotating member 2.

In the embodiment, the conductive liquid container 8 may be used together with the conductive connecting structures provided in the first to third embodiments. Taking the first embodiment as an example, with reference to Fig. 1, in addition to the first elastic conductive member 3 disposed between the first surface 21 and the second surface 11, the conductive liquid container 8 may also be provided to fill the gap between the first surface 21 and the second surface 11 with the conductive liquid.

However, the present disclosure is not limited to the above. In practical applications, the conductive connecting structure may be the conductive liquid container 8 alone, that is, only the conductive liquid container 8 is used to electrically connect the conductive stationary member 1 to the conductive rotating member 2. For example, the first elastic conductive member 3 in the first embodiment is replaced with the conductive liquid container 8. Optionally, the conductive stationary member 1 and the conductive rotating member 2 are embedded in each other as described in the first embodiment to allow the gap therebetween to be fully filled with the conductive liquid 9, so that the conductive liquid 9 can be uniformly distributed between the conductive stationary member 1 and the conductive rotating member 2.

In summary, in the power feeding mechanism provided in each of the above embodiments of the present disclosure, the conductive connecting structure can be in electrical contact with the conductive stationary member and the conductive rotating member respectively without affecting the rotation of the conductive rotating member, so that the power may be transmitted to the rotating component that is rotating. Meanwhile, because the conductive connecting structure is in electrical contact with the conductive stationary member and the conductive rotating member respectively, the power transmission efficiency is higher and the risk of ignition in the prior art can be avoided as compared with transmitting the power by means of inductive coupling in the prior art.

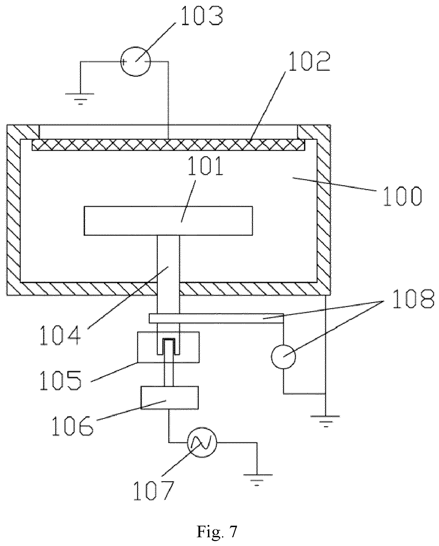

As another technical solution, with reference to Fig. 7, a fifth embodiment of the present disclosure provides a rotary base device, including a base 101 that is rotatable, a target 102, an upper radio frequency power supply 103, a bias power source, and a power feeding mechanism 105. The base 101 is disposed in a reaction chamber 100, and is the rotating component in the above embodiments. The target 102 is disposed above the base 101 and is electrically connected to the upper radio frequency power supply 103. The bias power source includes a matcher 106 and a power supply 107, the matcher 106 is used to dynamically adjust a variable capacitor in a matching circuit during a processing process to make load impedance be matched with the output impedance of the power supply 107, so as to ensure that the output power of the power supply 107 is applied to the plasma inside the chamber to the greatest extent. The power supply 107 includes a radio frequency power supply, a low frequency power supply, an intermediate frequency power supply, a direct current power supply, or the like.

The power feeding mechanism 105 is used to feed the output power of the bias power source into the base 101, and is the power feeding mechanism provided in each of the above embodiments of the present disclosure.

In the embodiment, the rotary base device further includes: a rotating shaft 104 and a rotation driving mechanism 108. The rotating shaft 104 is vertically disposed, and has an upper end connected with the base 101 and a lower end connected with the power feeding mechanism 105. The rotating shaft 104 is used as the conductive rotating member and is electrically connected with the base 101, and the lower part of the rotating shaft 104 is opposite to and spaced apart from the conductive stationary member. The conductive connecting structure is disposed in a gap between the rotating shaft 104 and the conductive stationary member to electrically connect the rotating shaft 104 to the conductive stationary member, thereby achieving power transmission. The rotation driving mechanism 108 is connected with a middle part between the upper end and the lower end of the rotating shaft 104, so as to drive the rotating shaft 104 to rotate.

The rotation driving mechanism 108 may include a motor and a transmission mechanism, and the motor is connected to the rotating shaft 104 through the transmission mechanism. The transmission mechanism may be, for example, a belt transmission mechanism, a gear transmission mechanism, etc. It should be noted that the rotation driving mechanism 108 bears the weight of the rotating shaft 104 and the base 101 thereon.

By adopting the power feeding mechanism provided in each of the above embodiments of the present disclosure, the rotary base device provided in the embodiment can not only improve the power transmission efficiency, but also avoid the risk of ignition in the prior art.

As another technical solution, with reference to Fig. 7, the embodiment of the present disclosure further provides a semiconductor processing equipment, including the reaction chamber 100, and the rotary base device provided in each of the above embodiments of the present disclosure, the rotary base device being disposed in the reaction chamber 100.

By adopting the power feeding mechanisms provided in the embodiments of the present disclosure, the semiconductor processing equipment provided in the embodiment can not only improve the power transmission efficiency, but also avoid the risk of ignition in the prior art.

It should be understood that the above embodiments are merely exemplary embodiments adopted to illustrate the principles of the present disclosure, and the present disclosure is not limited thereto. Various modifications and improvements of the present disclosure can be made by those skilled in the art without departing from the basis scope thereof, and the scope thereof is determined by the claims that follow.

## Claims

1. A power feeding mechanism for feeding output power of a power source into a rotating component, comprising:
a conductive stationary member (1), which is electrically connectable with the power source;
a conductive rotating member (2) which is electrically connectable with the rotating component and is arranged to synchronously rotate with the rotating component; and
a conductive connecting structure, which is in electrical contact with the conductive stationary member and the conductive rotating member, respectively, without affecting rotation of the conductive rotating member,
wherein the conductive rotating member is disposed opposite to and spaced apart from the conductive stationary member; and the conductive connecting structure is disposed in a gap between the conductive rotating member and the conductive stationary member; and
the conductive connecting structure comprises:
a second elastic conductive member (4), a third elastic conductive member (5) and a spring (7), wherein,
two ends of the spring are connected to the conductive stationary member and the second elastic conductive member thereabove, respectively;
the third elastic conductive member is provided on the second elastic conductive member and is kept in electrical contact with the conductive rotating member under action of elastic force of the spring; and
a hardness of the second elastic conductive member is lower than that of the third elastic conductive member; or
the conductive connecting structure comprises:
a second elastic conductive member (4'), which is connected with the conductive stationary member and is a ring body disposed around the conductive rotating member;
a third elastic conductive member (5'), which is connected with the conductive rotating member, is located between an inner wall surface of the ring body and an outer wall surface of the conductive rotating member, and is in electrical contact with the ring body and the conductive rotating member respectively; and wherein
a hardness of the second elastic conductive member is lower than that of the third elastic conductive member.

2. The power feeding mechanism of claim 1, wherein a surface of the conductive rotating member and a surface of the conductive stationary member that are opposite to each other are parallel to each other or are embedded in each other.

3. The power feeding mechanism of claim 1, wherein the conductive rotating member is provided with a recess (23), and at least a part of the second elastic conductive member is located in the recess.

4. The power feeding mechanism of claim 1, wherein the conductive connecting structure further comprises a fixing seat (6) connected to the spring; and a mounting groove is provided on the fixing seat, and the second elastic conductive member is detachably fixed in the mounting groove.

5. The power feeding mechanism of claim 1, wherein the second elastic conductive member is made of graphite or a soft alloy.

6. The power feeding mechanism of any one of claims 1 to 5, further comprising a conductive liquid container (8), and a part of the conductive stationary member and a part of the conductive rotating member are immersed in a conductive liquid (9) in the conductive liquid container, so as to electrically connect the conductive stationary member to the conductive rotating member through the conductive liquid; the conductive liquid container is connected to the conductive stationary member or the conductive rotating member; or the conductive connecting structure comprises a conductive liquid container, and a part of the conductive stationary member and a part of the conductive rotating member are immersed in a conductive liquid in the conductive liquid container, so as to electrically connect the conductive stationary member to the conductive rotating member through the conductive liquid.

7. The power feeding mechanism of claim 1, wherein the rotating component comprises a base, a target or a coil.

8. A rotary base device, comprising a rotatable base (101), a bias power source (106, 107), and a power feeding mechanism (105) configured to feed output power of the bias power source into the base, wherein the power feeding mechanism is the power feeding mechanism of any one of claims 1 to 7.

9. Semiconductor processing equipment, comprising a reaction chamber (100), wherein the rotary base device of claim 8 is disposed in the reaction chamber.

## Patentansprüche

1. Energieeinspeisungsmechanismus zum Einspeisen von Ausgangsenergie einer Energiequelle in eine rotierende Komponente, aufweisend:
ein leitendes stationäres Element (1), das elektrisch mit der Energiequelle verbindbar ist;
ein leitendes rotierendes Element (2), das elektrisch mit der rotierenden Komponente verbindbar ist und angeordnet ist, um sich synchron mit der rotierenden Komponente zu drehen; und
eine leitende Verbindungsstruktur, die in elektrischem Kontakt mit dem leitenden stationären Element bzw. dem leitenden rotierenden Element steht, ohne die Drehung des leitenden rotierenden Elements zu beeinflussen,
wobei das leitende rotierende Element gegenüber des leitenden stationären Elements und mit einem Abstand davon angeordnet ist; und die leitende Verbindungsstruktur in einem Spalt zwischen dem leitenden rotierenden Element und dem leitenden stationären Element angeordnet ist; und
die leitende Verbindungsstruktur aufweist:
ein zweites elastisches leitendes Element (4), ein drittes elastisches leitendes Element (5) und eine Feder (7),
wobei,
zwei Enden der Feder jeweils mit dem leitenden stationären Element und dem darüber befindlichen zweiten elastischen leitenden Element verbunden sind;
das dritte elastische leitende Element auf dem zweiten elastischen leitenden Element vorgesehen ist und unter der Wirkung der elastischen Kraft der Feder in elektrischem Kontakt mit dem leitenden rotierenden Element gehalten wird; und
eine Härte des zweiten elastischen leitenden Elements geringer ist als die des dritten elastischen leitenden Elements; oder
die leitende Verbindungsstruktur aufweist:
ein zweites elastisches leitendes Element (4'), das mit dem leitenden stationären Element verbunden ist und ein Ringkörper ist, der um das leitende rotierende Element angeordnet ist;
ein drittes elastisches leitendes Element (5'), das mit dem leitenden rotierenden Element verbunden ist, zwischen einer inneren Wandfläche des Ringkörpers und einer äußeren Wandfläche des leitenden rotierenden Elements angeordnet ist und in elektrischem Kontakt mit dem Ringkörper bzw. dem leitenden rotierenden Element steht; und wobei eine Härte des zweiten elastischen leitenden Elements geringer ist als diejenige des dritten elastischen leitenden Elements.

2. Energieeinspeisungsmechanismus nach Anspruch 1, wobei eine Fläche des leitenden rotierenden Elements und eine Fläche des leitenden stationären Elements, die einander gegenüberliegen, parallel zueinander sind oder ineinander eingebettet sind.

3. Energieeinspeisungsmechanismus nach Anspruch 1, wobei das leitende rotierende Element mit einer Aussparung (23) versehen ist und mindestens ein Teil des zweiten elastischen leitenden Elements in der Aussparung angeordnet ist.

4. Energieeinspeisungsmechanismus nach Anspruch 1, wobei die leitende Verbindungsstruktur ferner einen Befestigungssitz (6) aufweist, der mit der Feder verbunden ist; und
eine Befestigungsnut auf dem Befestigungssitz vorgesehen ist und das zweite elastische leitende Element abnehmbar in der Befestigungsnut befestigt ist.

5. Energieeinspeisungsmechanismus nach Anspruch 1, wobei das zweite elastische leitende Element aus Graphit oder einer weichen Legierung hergestellt ist.

6. Energieeinspeisungsmechanismus nach einem der Ansprüche 1 bis 5, ferner einen Behälter (8) für leitende Flüssigkeit aufweisend, wobei ein Teil des leitenden stationären Elements und ein Teil des leitenden rotierenden Elements in eine leitende Flüssigkeit (9) in dem Behälter für leitende Flüssigkeit eingetaucht sind, um das leitende stationäre Element mit dem leitenden rotierenden Element durch die leitende Flüssigkeit elektrisch zu verbinden;
der Behälter für leitende Flüssigkeit mit dem leitenden stationären Element oder dem leitenden rotierenden Element verbunden ist; oder die leitende Verbindungsstruktur einen Behälter für leitende Flüssigkeit aufweist, und ein Teil des leitenden stationären Elements und ein Teil des leitenden rotierenden Elements in eine leitende Flüssigkeit in dem Behälter für leitende Flüssigkeit eingetaucht sind, um das leitende stationäre Element mit dem leitenden rotierenden Element durch die leitende Flüssigkeit elektrisch zu verbinden.

7. Energieeinspeisungsmechanismus nach Anspruch 1, wobei die rotierende Komponente eine Basis, ein Target oder eine Spule aufweist.

8. Drehbare Basisvorrichtung, eine drehbare Basis (101), eine Vorspannungsenergiequelle (106, 107) und einen Energieeinspeisungsmechanismus (105) aufweisend, der konfiguriert ist, um eine Ausgangsenergie der Vorspannungsenergiequelle in die Basis einzuspeisen, wobei der Energieeinspeisungsmechanismus der Energieeinspeisungsmechanismus nach einem der Ansprüche 1 bis 7 ist.

9. Halbleiterbearbeitungsanlage, eine Reaktionskammer (100) aufweisend, wobei die drehbare Basisvorrichtung nach Anspruch 8 in der Reaktionskammer angeordnet ist.

## Revendications

1. Un mécanisme d'alimentation électrique pour alimenter une puissance de sortie d'une source d'alimentation dans un composant rotatif, comprenant :
un élément stationnaire conducteur (1), qui est apte à être connecté électriquement à la source d'alimentation ;
un élément rotatif conducteur (2) qui est apte à être connecté électriquement au composant rotatif et est agencé pour tourner de manière synchrone avec le composant rotatif ; et
une structure de connexion conductrice, qui est en contact électrique avec l'élément stationnaire conducteur et l'élément rotatif conducteur, respectivement, sans affecter la rotation de l'élément rotatif conducteur,
l'élément rotatif conducteur étant disposé à l'opposé de l'élément stationnaire conducteur et espacé de celui-ci ; et
la structure de connexion conductrice est disposée dans un espace entre l'élément rotatif conducteur et l'élément stationnaire conducteur ; et la structure de connexion conductrice est disposée dans un espace entre l'élément rotatif conducteur et l'élément stationnaire conducteur ; et
la structure de connexion conductrice comprend : un deuxième élément conducteur élastique (4), un troisième élément conducteur élastique (5) et un ressort (7),
dans lequel
deux extrémités du ressort sont connectées à l'élément stationnaire conducteur et au deuxième élément conducteur élastique au-dessus de celui-ci, respectivement ;
le troisième élément conducteur élastique est prévu sur le deuxième élément conducteur élastique et est maintenu en contact électrique avec l'élément rotatif conducteur sous l'action de la force élastique du ressort ; et
une dureté du deuxième élément conducteur élastique est inférieure à celle du troisième élément conducteur élastique ; ou
la structure de connexion conductrice comprend :
un deuxième élément conducteur élastique (4'), qui est relié à l'élément stationnaire conducteur et est un corps annulaire disposé autour de l'élément rotatif conducteur ;
un troisième élément conducteur élastique (5'), qui est relié à l'élément rotatif conducteur, est situé entre une surface de paroi interne du corps annulaire et une surface de paroi externe de l'élément rotatif conducteur, et est en contact électrique avec le corps annulaire et l'élément rotatif conducteur respectivement ; et
dans lequel une dureté du deuxième élément conducteur élastique est inférieure à celle du troisième élément conducteur élastique.

2. Le mécanisme d'alimentation électrique selon la revendication 1, dans lequel une surface de l'élément rotatif conducteur et une surface de l'élément stationnaire conducteur qui sont opposées l'une à l'autre sont parallèles l'une à l'autre ou sont encastrées l'une dans l'autre.

3. Le mécanisme d'alimentation électrique selon la revendication 1, dans lequel l'élément rotatif conducteur est pourvu d'un évidement (23), et au moins une partie du deuxième élément conducteur élastique est située dans l'évidement.

4. Le mécanisme d'alimentation électrique selon la revendication 1, dans lequel la structure de liaison conductrice comprend en outre un siège de fixation (6) relié au ressort ; et
une rainure de montage est prévue sur le siège de fixation, et le deuxième élément conducteur élastique est fixé de manière amovible dans la rainure de montage.

5. Le mécanisme d'alimentation électrique selon la revendication 1, dans lequel le deuxième élément conducteur élastique est en graphite ou en un alliage mou.

6. Le mécanisme d'alimentation électrique selon l'une quelconque des revendications 1 à 5, comprenant en outre un récipient (8) de liquide conducteur, et une partie de l'élément conducteur stationnaire et une partie de l'élément conducteur rotatif sont immergées dans un liquide conducteur (9). dans le récipient de liquide conducteur, de manière à connecter électriquement l'élément stationnaire conducteur à l'élément rotatif conducteur par l'intermédiaire du liquide conducteur ;
le récipient à liquide conducteur est relié à l'élément conducteur stationnaire ou à l'élément conducteur rotatif ; ou la structure de connexion conductrice comprend un récipient de liquide conducteur, et une partie de l'élément stationnaire conducteur et une partie de l'élément rotatif conducteur sont immergées dans un liquide conducteur dans le récipient de liquide conducteur, de manière à connecter électriquement l'élément stationnaire conducteur à l'élément rotatif conducteur au moyen du liquide conducteur.

7. Le mécanisme d'alimentation électrique selon la revendication 1, dans lequel le composant rotatif comprend une base, une cible ou une bobine.

8. Le dispositif à base rotative, comprenant une base rotative (101), une source d'alimentation de polarisation (106, 107) et un mécanisme d'alimentation électrique (105) configuré pour alimenter une puissance de sortie de la source d'alimentation de polarisation dans la base, le mécanisme d'alimentation électrique étant le mécanisme d'alimentation électrique selon l'une quelconque des revendications 1 à 7.

9. Équipement de traitement de semi-conducteurs, comprenant une chambre de réaction (100), dans lequel le dispositif à base rotative selon la revendication 8 est disposé dans la chambre de réaction.
